Europäisches Patentamt

(19) **European Patent Office**

Office européen des brevets

(11) Publication number: **0 006 717**
**B1**

(12) **EUROPEAN PATENT SPECIFICATION**

(45) Date of publication of patent specification: **14.07.82**

(21) Application number: **79301140.4**

(22) Date of filing: **14.06.79**

(51) Int. Cl.³: **H 03 K 13/02,
G 01 R 19/165**

(54) Analog to digital converter.

(30) Priority: **23.06.78 US 918251**
**23.06.78 US 918254**

(43) Date of publication of application:
**09.01.80 Bulletin 80/1**

(45) Publication of the grant of the patent:
**14.07.82 Bulletin 82/28**

(84) Designated Contracting States:
**DE GB NL**

(56) References cited:
**FR - A - 2 334 245**
**US - A - 3 903 543**
**US - A - 3 930 255**
**US - A - 3 958 210**
**US - A - 4 072 938**

(73) Proprietor: **XEROX CORPORATION**
**Xerox Square - 020**
**Rochester New York 14644 (US)**

(72) Inventor: **Handy, Roland J.**
**8611 Paso Robles**
**Northridge California 91325 (US)**

(74) Representative: **Goode, Ian Roy et al,**
**European Patent Attorney c/o Rank Xerox Patent
Department 338 Euston Road
London NW1 3BH (GB)**

Courier Press, Leamington Spa, England.

The invention relates to an analog to digital converter on a single integrated circuit chip utilizing charge transfer technology. One known kind of analog to digital converter comprises a cell including input gate means for receiving an input analog signal represented by packets of charge, and transfer gate means coupled to said input gate means for transferring any such packets of charge.

Charge-coupled semiconductor devices were first described in an article of similar title as published in the Bell System Technical Journal, Volume 49, Number 4, 1970, pages 587 to 593. Since that time much research has been conducted on CCD's to the present time wherein 64 kilo-bit single chip CCD memories have reached the commercial marketplace. (IEEE Spectrum, May 1978, page 36).

Memories are not the only use for CCD's however. CCD's can be utilized in image sensing arrays and also for analog signal processors (Electronic Design 6, March 15, 1976, page 70). Furthermore, an example of the known kind of analog to digital converter mentioned above is described in French Patent Specification no. 2 334 245. However, the prior art does not show the use of CCD technology to provide an analog to digital converter wherein the actual conversion is accomplished directly on the CCD integrated circuit chip itself.

It is an object of the present invention to overcome this deficiency and to provide an analog to digital converter of the known kind mentioned above which is characterised by floating gate means coupled to said transfer gate means for detecting the presence of charge transferred, an excess of charge transferred, or no charge transferred, the output of said floating gate means being a pair of digital logic voltage signals indicative of these three conditions.

Such a device reduces the number of CCD and other type integrated circuit chips and increases signal to noise, amplification ratios, etc., due to the fact that the entire analog to digital conversion is done on one device.

In a preferred embodiment of the invention, a plurality of said cells are arranged in serial fashion on said single integrated circuit chip in charge transfer proximity to one another to thereby form an analog to digital register of said plurality of cells.

As large scale integrated circuit techniques are extensive in the modern technology, construction of more than one such analog to digital conversion circuit on one chip is possible. Thus, coupling the CCD A/D conversion cells together by transfer gate technology leads to the construction of a multi-stage analog to digital converter on a single LSI chip utilizing CCD technology.

Coupling more than one cell to another will allow for multi-bit outputs to be generated in increasing resolution depending on the number of stages. That is, if 16 cells are coupled together, 16 levels of gray can be detected, if used in an imaging system for example, or 16 discrete digital voltage levels can be detected from the input analog signals. Transfer gates are used to couple successive cells to each other to provide conduction paths for the packets of charge generated.

For a more complete understanding of the invention, reference may be had to the following detailed description of the invention in conjunction with the drawings wherein:

Figure 1 is a schematic representation of an analog to digital signal converter cell utilizing the charge-coupled transfer technology;

Figure 2 is a timing diagram of the application of voltage signals to the converter described in conjunction with Figure 1; and

Figure 3 is a schematic representation of the multi-stage analog to digital converter utilizing a plurality of cells shown and described in conjunction with Figures 1 and 2.

Charge coupled devices are inherently analog devices due to the fact that the charge packets associated with each individual charge coupled device on a silicon substrate vary from zero to a predetermined maximum value, depending upon the applied voltage to that particular CCD. Thus, charge coupled devices are ideal for use wherein an input signal is of an analog nature which can be subsequently utilized with subsequent circuitry for modifying, encoding, amplifying, etc., any particular signal output. Further, CCD's lend themselves to large scale integrated circuit techniques for manufacture where the density of the circuits on a substrate chip run into the thousands and which allow CCD's to be valuable in analog situations. In certain instances, an analog signal is desired to be converted to digital signals, and many such techniques are old in the art, as analog to digital conversion is a well known technique and has been for many years. However, analog to digital conversion using charge transfer technology in a charge coupled device is a new concept and the art is sparse in this area. One such reference is entitled "An Analog to Digital Converter Using Charge Transfer Technology" on Page 4 of the 1977 IEEE International Solid State Circuits Conference Proceedings.

However, a charge coupled device which is able to convert a signal from analog to digital form on one integrated circuit chip has not been disclosed in the prior art previous to this application.

The obvious advantages of utilizing analog to digital conversion on a single chip are many fold. For example, converting an analog signal to a digital signal within the confines of a single charge coupled device integrated circuit chip allows for much higher accuracy in the conversion process because the obvious use of fewer circuits and components decreases the chances for error, noise, etc. Further, analog to digital conversion on a single integrated circuit chip allows for immediate digital operation in essentially an analog environment.

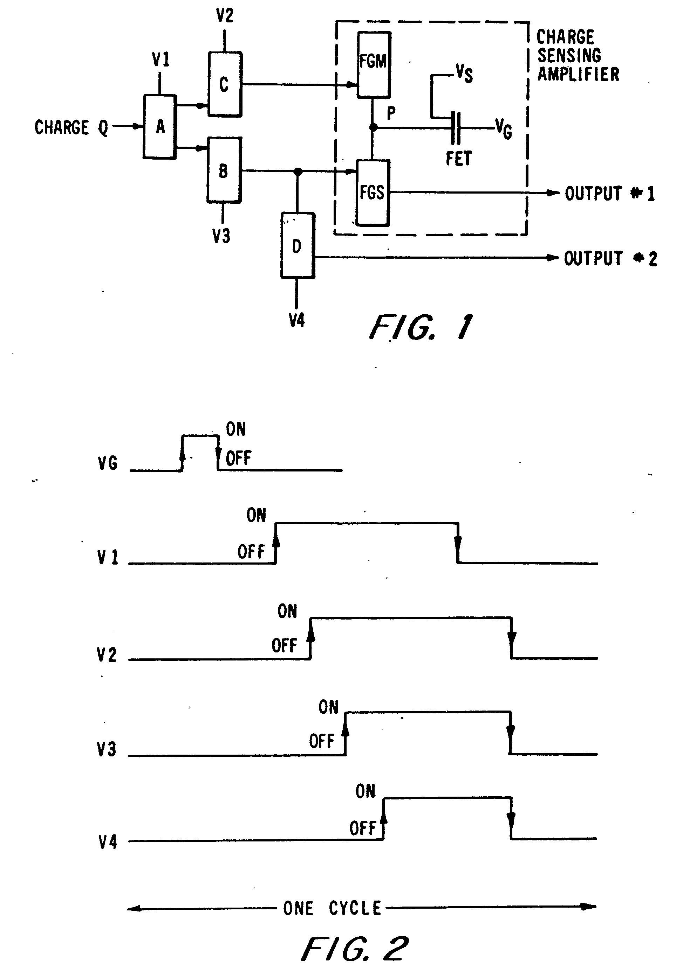

Figure 1 shows a typical cell embodying the principles of the present invention. Since the individual gates and other components shown in Figure 1 may be part of a larger integrated circuit, the arrows shown are not strictly electrical connections in the typical sense, but are paths for which either a charge or a voltage is applied or for charge to be moved from one area to another on the integrated circuit chip. Thus, Figure 1 shows an input gate A and as an input to the gate there is a charge path for which charge may be applied to the gate. Also, connected to input gate A is a voltage V1 which is applied to establish the depth of the depletion layer to establish the amount of charge that can be stored in the input gate. Figure 2 depicts a timing diagram for the application of the various voltage potentials. From input gate A are shown two arrows which denote paths of movement of charge from this depletion layer to gates B and C. Coupled to the input of gate B is voltage V3 and coupled to gate C is voltage V2 which establish the depletion layers for these gates, respectively.

Also shown in Figure 1 is a charge sensing amplifier CSA which comprises a floating gate master FGM and floating gate slave FGS which are coupled together to a field effect transistor FET. Coupled to the intersection of the line from the FGM and the FGS is a line coupled to the source of the field effect transistor FET. Coupled to the drain of the FET is voltage VS and coupled to the gate of the FET is voltage VG. Also coupled to the path between gate B and the FGS is gate D which has an input of voltage V4. The output from the FGS is considered Output Number 1 and the output of gate D is considered the Output Number 2. These outputs have on the line a voltage level of a logic zero or a voltage level of a logic one in binary terms. This is a digital output which can be used for a subsequent operation either on the integrated circuit chip itself or directed to an output circuit as will be discussed below. However, it is to be understood that an analog charge Q applied to analog gate A generates, in a manner to be hereinafter described, voltage signals on Outputs Numbers 1 and 2 which are seen to be digital.

The charge input into input gate A for purposes of explaining the operation of the circuit in Figure 1, is, for ease of description, defined as being at 2Q. This charge can be generated in any of the known manners for use in operating a charge coupled device, such as from another stage in a charge coupled device or from the use of the charge coupled device in an imaging technique wherein light impinges upon a photosite, such as is used when CCD's are used in an imaging environment. If the charge of 2Q is applied to input gate A when the predetermined voltage V1 is applied to gate A, the depletion layer formed at gate A by the voltage will be quickly filled with the charge in the manner known in the art in the operation of charge coupled devices. As described above, CCD gates C and B are coupled to the output of gate A. Upon application of voltage V2 (see Figure 2) on gate C, and if the voltage V2 is also carefully predetermined, the excess charge of 1Q occupying the depletion layer in gate A will be quickly transferred to gate C in the normal CCD charge transfer technique. In the charge sensing amplifier, CSA, the voltage VS is applied to the drain terminal of the field effect transistor FET which is part of the integrated circuit on the chip along with the rest of the CCD circuit being described herein. When voltage VG is applied to the field effect transistor FET at the gate terminal, the voltage VS is immediately applied to point P which is shown to be between the floating gate master FGM and the floating gate slave FGS. Once voltage VS is applied to point P, voltage VG is turned off and the voltage VS will remain at point P. Thus, in order to energize initially the FGM and the FGS, voltage VG will be applied prior to applying voltage V1 to input gate A. If voltage VG had been applied initially as just explained, when voltage V2 is applied to gate C, and there is an excess charge of Q in the input gate A, this charge will be transferred through gate C to the FGM. When charge is deposited under the FGM gate, the surface potential under the FGS gate will be changed toward zero volts.

Returning to input gate A, the remaining charge Q is detected at gate B and is transferred, when voltage V3 is applied to gate B to the FGS. Since the FGS surface potential has increased from its initial position, because of charge being deposited under the FGM gate, the charge under gate B, if there is any, will be blocked by the surface potential barrier under the FGS gate. Thus, the ouput of the FGS will remain at a logic zero. However, since the charge from gate B has not been transferred to the FGS, when voltage V4 is applied to gate D, gate D will now have the charge transfer from gate D, gate D will now have the charge transfer from gate B to gate D, and thus at the application of voltage V4 the charge will be transferred through gate D to the output and detected as a logic one. Thus, when a charge of 2Q or maximum charge to fill input gate A is applied to gate A, Output 1 will have a logic zero and Output 2 will have a logic one.

Assume now that only a charge of Q is applied to gate A. Voltage VG had been applied to the FET and thus voltage VS appears at point P between FGM and FGS. Since there is no excess charge in gate A after application of voltage V1, upon the application of voltage V2 to gate C, no excess charge is transferred via gate C from gate A to the FGM. Accordingly, there is no change of the surface potential of the FGS from the influence of the FGM. Therefore, when voltage V3 is applied to gate B, the charge Q in gate A will be transferred to gate B. However, as voltage VS appears at point P, FGS is enabled and thus when voltage V3 is applied to gate B, the charge Q on gate A will be transferred via gate B to the FGS which now detects the charge and the Output Number 1 may be considered, therefore, to be a logic one. When it comes time for voltage V4 to be applied to gate D, no charge remains on input gate A to be transferred via gate B and thus Output 2 is considered a logic zero. Thus, when only a charge of Q appears at input Gate A, Output 1 is a logic one and Output 2 is a logic zero.

When the input charge to gate A is zero, no charge can be transferred to either FGM or gate D and thus the output at Outputs 1 and 2 are both logic zero. Accordingly, it is apparent then that depending upon the charge level applied to the input gate A, the output from Outputs 1 and 2 will be the logic levels as set forth above. Further, a charge applied to gate A less than Q will render Output 1 at logic one and Output 2 at logic zero. Thus, the cell described in Figure 1 will operate as a true analog to digital converter. For ease of description, the input charge was defined as 2Q. The charge, in actuality, can be any defined level, the circuit will divide the charge in half.

The description above has related to the description of how one CCD cell effects the analog to digital conversion. By the use of a plurality of these cells and transfer gates to couple them together, the multi-stage analog to digital converter of the present invention can be constructed.

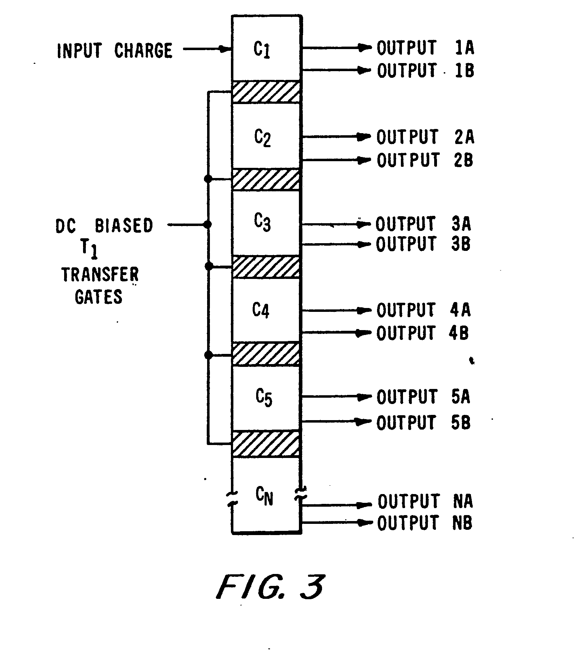

Attention is now drawn to Figure 3. Each rectangle with a C in it is representative of one CCD cell described above in configuration with Figures 1 and 2. For convenience, the various inputs and outputs of the single cell described above will be listed here:

2Q input, Output Number 1 is *logic 0*.
2Q input, Output Number 2 is *logic 1*.

1Q input, Output Number 1 is *logic 1*.
1Q input, Output Number 2 is *logic 0*.

No input, Output Number 1 is *logic o*.
No input, Output Number 2 is *logic 0*.

Figure 3 depicts at least five of such cells with a possibility of N cells. Only the state of the art in the manufacture of integrated circuits limits the number of cells that may be constructed on a single silicon chip. Each of the cells has an input to a gate A as seen in Figure 1. However, only cell C1 in Figure 3 receives an input charge from an external source. The other input gates receive the excess charge packets over and above what is capable of saturating the depletion layer in gate A of cell 1. This excess charge is transferred from cell 1 to cell 2 towards cell N, filling each depletion layer on its way, by means of the transfer gate constructed between the input gates A of the plurality of cells in the register or array.

Each of these cells operates in the same manner. For example, if the cell receives the defined charge of 2Q, Output 1 would be a logic zero and Output 2 would be a logic one. Thus, if cell C5 received a charge of 2Q, for example, Output 5A would be a logic zero and Output 5B would be a logic one, and so forth.

Referring to Figure 3, it is to be assumed for purposes of illustration that the input charge to cell C1 is 7Q. Cell C1 would fill its depletion layer to 2Q and 5Q would spill over to cell C2. Cell C2 would fill its depletion layer to 2Q and 3Q would spill over to cell C3. Cell C3 would fill its depletion layer to 2Q and 1Q would spill over to cell C4. Cell C5 received no charge at all. Referring to the chart above, the outputs from cells C1, C2, and C3 would be the same, or logic zero and logic one respectively from the Outputs A and B. Cell C4, having only received 1Q of charge would have at its outputs 4A and 4B, logic one and logic zero, respectively. Cell C5, having received no charge at all, would have at its outputs 5A and 5B, logic zero and logic zero, respectively. Depending on the amount of input charge received and the number of cells, the Outputs of the respective cells will have a representative number of cells with its Outputs the same (cells C1, C2, C3, for example), one cell could have a transition logic level (cell C4, for example), and the remaining cells could have its outputs the same, but opposed to the first group of cells (cells C5 to CN, for example).

It can, therefore, be clearly seen that the multi-stage array as set forth in Figure 3 generates digital signals specifically related to the applied analog signal. This invention has application whenever analog signals must be converted to a multi-level digital signal. For example, in data transmission modems, it may be desired to convert the analog signal to a multi-level digital signal, with each level encoded at a different transmission frequency. The present invention would accomplish the analog to digital conversion on a single CCD integrated circuit chip.

Another application of the invention described herein is in the use with image devices. An image can be scanned and a signal generated, as at the output of a photocell, for example. Or the light may impinge directly on a photosite on the CCD integrated circuit directly. In any event, the charge, defined as Q, is generated in proportion to the amount of light received from the image. (Or the reverse if a reverse or negative image is scanned or desired.) If, for instance, there were sixteen cells in the array described in conjunction with Figure 3, the light level would have been discerned to change at the output level gnerated by Cell C4.

Cells C1 to C3 would be a value lighter than the detected level while cells C5 to C16 would be a value darker than the detected level. Or it can be said that the light received was level 4 on a gray scale range of 1 to 16.

Subsequent logic circuitry coupled to the outputs of the cells can be used for detection, encoding, etc. of the detected gray levels. This logic circuitry could be part of the integrated circuit or external to the integrated circuit. In one instance, for example, the logic levels from Outputs 1 and 2 from each cell of logic zero and logic one could be searched for alone, because all the values above this cell would be the same while all the values below the cell would be the same, but different of course from the opposite level detected. This would mean that only the outputs from one cell have to be encoded, because the other cells' outputs may be redundant.

This invention would readily be adaptable for considerable use and value in an imaging system where analog to digital conversion is a necessity. Facsimile and digital television transmission are typical examples.

### Claims

1. An analog to digital converter on a single integrated circuit chip utilizing charge transfer technology, comprising a cell which includes:

input gate means (A) for receiving an input analog signal represented, by packets of charge, and

transfer gate means (B), (C) coupled to said input gate means for transferring any such packets of charge, the cell being characterised by

floating gate means (FGM), (FGS) coupled to said transfer gate means for detecting the presence of charge transferred, an excess of charge transferred, or no charge transferred, the output of said floating gate means being a pair of digital logic voltage signals indicative of these three conditions.

2. The analog to digital converter as claimed in Claim 1, wherein said transfer gate means comprises:

first and second transfer gates in charge packet transfer relationship with said input gate means, said first transfer gate (C) transferring charge in excess of a predetermined charge, and said second transfer gate (B) transferring a charge at or below said predetermined charge, the charge levels being determined by the depletion levels established by applied voltage levels (V1, V2, V3).

3. The analog to digital converter as claimed in Claim 1 or Claim 2 wherein said floating gate means comprises:

a master floating gate (FGM) and a slave floating gate (FGS) in charge packet transfer relationship with said first and second transfer gates (C), (B) respectively, said floating gates having applied thereto a voltage (VS) which is independent from other applied voltages, said master floating gate (FGM) inducing a change in the potential in said slave floating gate (FGS) whereby said slave floating gate (FGS) blocks the transfer of charge from said second transfer gate (B) when said master floating gate (FGM) detects an excess charge transferred by said first transfer gate (C).

4. The analog to digital converter as claimed in Claim 3 wherein said transfer gate means further comprises a third transfer gate (D) in charge packet transfer relationship with said second transfer gate (B), said third transfer gate (D) transferring any charge remaining in said second transfer gate (B) that may have been blocked by said slave floating gate (FGS), the charge level on said third transfer gate (D) being determined by the depletion level established by an applied voltage level (V4).

5. The analog to digital converter as claimed in Claim 3 or Claim 4 wherein said voltage (VS) applied to said master and slave floating gates is applied via a voltage switched field-effect transistor (FET).

6. An analog to digital converter as claimed in any one of Claims 1 to 5, wherein a plurality of said cells are arranged in serial fashion on said single integrated circuit chip in charge transfer proximity to one another to thereby form an analog to digital register of said plurality of cells.

7. An analog to digital converter as claimed in Claim 6 including an additional transfer gate between each adjacent pair of said cells to effect charge transfer from cell to cell, whereby charges in excess of that capable of being transferred within the first cell in the series are transferred to the second cell by said transfer gate and so on through the series until all the incoming charge has been transferred within the cells, the output of those cells to which charge has been transferred from the preceding cell being of a different logic configuration from the output of those cells to which no charge was transferred, thereby indicating a digital logic signal representative of the input analog charge level.

8. The analog to digital converter as claimed in Claim 7 wherein the output signals from said register are indicative of a level of gray if the input analog charge applied to said converter is representative of an image signal of varying shading levels.

9. The analog to digital converter as claimed in Claim 7 wherein the output signal is a digital logic representation of the applied analog charge level according to the ratio S/N, where S is the number of the stage in the converter wherein the output signals of the first cells of the converter change in relation to the remaining cells of the converter, and N is the number of cells in the converter.

## Revendications

1. Convertisseur analogique/numérique sur puce unique de circuit intégré faisant appel à la technologie du transfert de charge, comprenant une cellule incluant:
— un moyen de porte d'entrée (A) pour recevoir un signal analogique d'entrée représenté par des groupes de charge, et
— un moyen de porte de transfert (B), (C) couplé au moyen de porte d'entrée pour le transfert desdits groupes de charge, caractérisé en ce que la cellule comporte un moyen de porte flottante (FGM), (FGS) couplé au moyen de porte de transfert pour détecter la présence de la charge transférée, un excès de charge transféré ou l'absence d'un transfert de charge, la sortie de ce moyen de porte flottante étant une paire de signaux de tension logiques numériques indicateurs de ces trois conditions.

2. Convertisseur analogique/numérique selon la revendication 1, caractérisé en ce que le moyen de porte de transfert comprend:
— des première et seconde portes de transfert en relation de transfert de groupes de charge avec le moyen de porte d'entrée, cette première porte de transfert (C), transférant une charge en excès d'une charge prédéterminée, et cette seconde porte de transfert (B) transférant une charge à la charge prédéterminée ou au-dessous de cette charge, les niveaux de charge étant déterminés par les niveaux d'appauvrissement établis par les niveaux des tensions appliquées (V1, V2, V3).

3. Convertisseur analogique/numérique selon la revendication 1 ou la revendication 2, caractérisé en ce que le moyen de porte flottante comprend:
— une porte flottante maître (FGM) et une porte flottante asservie (FGS) en relation de transfert de groupes de charge avec les première et seconde portes de transfert (C), (B), respectivement, les portes flottantes étant soumises à une tension (VS) qui est indépendante des autres tensions appliquées, la porte flottante maître (FGM) conférant un changement du potentiel dans la porte flottante asservie (FGS), d'où il résulte que la porte flottante asservie (FGS) bloque le transfert de charge à partir de la seconde porte de transfert (B) lorsque la porte flottante maître (FGM) détecte une charge en excès transférée par la première port de transfert (C).

4. Convertisseur analogique/numérique selon la revendication 3, caractérise en ce que le moyen de porte de transfert comprend en outre une troisième porte de transfert (D) en relation de transfert de groupes de charge avec la seconde porte de transfert (B), cette troisième porte de transfert (D) transférant toute charge restant dans la seconde porte de transfert (B) qui peut avoir été bloquée par la porte flottante asservie (FGS), le niveau de charge de la troisième port de transfert (D) étant déterminé par le niveau d'appauvrissement établi par un niveau de tension appliquée (V4).

5. Convertisseur analogique/numérique selon la revendication 3 ou la revendication 4, caractérisé en ce que la tension (VS) appliquée aux portes flottantes maître et asservie est appliquée via un transistor à effet de champ (FET) commuté en tension.

6. Convertisseur analogique/numérique selon l'une quelconque des revendications 1 à 5, caractérisé en ce qu'une pluralité de cellules sont disposées en série sur la puce unique de circuit intégré en proximité de transfert de charge les unes vis-à-vis des autres de façon à former un registre analogique/numérique de la pluralité de cellules.

7. Convertisseur analogique/numérique selon la revendication 6, caractérisé en ce qu'il comprend une porte de transfert supplémentaire entre chaque pair contiguë de cellules de façon à effectuer le transfert de charge de cellule à cellule, d'où il résulte que des charges en excès de celles capables d'être transférées à l'intérieur de la première cellule dans la série sont transférées à la seconde cellule par la porte de transfert etc.... dans la série jusqu'à ce que toute la charge d'entrée ait été transférée à l'intérieur des cellules, la sortie de ces cellules auxquelles la charge a été transférée à partir de la cellule précédente ayant une configuration logique différente de la sortie des cellules auxquelles aucune charge n'a été transférée, ce qui a pour effet d'indiquer un signal logique numérique représentatif du niveau de charge analogique d'entrée.

8. Convertisseur analogique/numérique selon la revendication 7, caractérisé en ce que les signaux de sortie en provenance du registre sont indicateurs d'un niveau de gris si la charge analogique d'entrée appliquée au convertisseur est représentative d'un signal d'image de niveaux de dégradation variables.

9. Convertisseur analogique/numérique selon la revendication 7, caractérisé en ce que le signal de sortie est une représentation logique numérique au niveau de charge analogique appliqué selon le rapport E/N, où E est le numéro de l'étage dans le convertisseur où les signaux de sortie des premières cellules du convertisseur ont une relation variable par rapport aux cellules restantes du convertisseur, et N est le nombre de cellules dans le convertisseur.

## Patentansprüche

1. Ein Analog-Digital-Wandler auf einem einzigen integrierten Schaltkreis-Chip, der die Ladungs-Verschiebungs-Technologie benutzt, mit einer Zelle, die folgendes beinhaltet:
Eine Eingagsgatter-Vorrichtung (A) zum Empfangen eines analogen Eingangssignals, das durch Ladungspakete verkörpert wird und
eine Übertragungsgatter-Vorrichtung (B), (C), die an die genannte Eingangsgatter-Vorrichtung zur Übertragung solcher Ladungspakete angeschlossen ist, wobei die Zelle gekennzeichnet ist durch eine potentialfreie Gatter-Vorrichtung (FGM), (FGS), die an die genannte Übertragungsgatter-Vorrichtung angeschlossen ist, um das Vorliegen von übertragener Ladung, einen Überschuß von übertragener Ladung oder keine übertragene Ladung zu erfassen, wobei der Ausgang der genannten potentialfreien Gatter-Vorrichtung ein Paar von digitalen logischen Spannungssignalen ist, die diese drei Zustände anzeigen.

2. Der Analog-Digital-Wandler nach Anspruch 1, in dem die genannte Übertragungsgatter-Vorrichtung folgendes umfaßt:

Erste und zweite Übertragungsgatter in Ladungspaket übertragender Beziehung mit der genannten Eingangsgattervorrichtung, wobei das genannte erste Übertragungsgatter (C) eine Ladung überträgt, die eine vorbestimmte Ladung übersteigt, und das genannte zweite Übertragungsgatter (B) eine Ladung bei oder unterhalb der genannten vorbestimmten Ladung überträgt, wobei die Ladungsniveaus durch die Verrarmungsniveaus festgelegt sind, die durch angelegte Spannungsniveaus (V1, V2, V3) hervorgerufen werden.

3. Der Analog-Digital-Wandler nach Anspruch 1 oder 2, in dem die genannte potentialfreie Gatter-Vorrichtung folgendes beinhaltet:

Ein potentialfreies führendes Gatter (FGM) (master floating gate) und ein potentialfreies geführtes Gatter (FGS) (slave floating gate) in Ladungspaket übertragender Beziehung mit jeweils den genannten ersten und zweiten Übertragungsgattern (C), (B), wobei an den genannten potentialfreien Gattern eine Spannung (VS) anliegt, die unabhängig von anderen angelegten Spannungen ist, wobei das genannte potentialfreie führende Gatter (FGM) einen Potentialwechsel in das genannte potentialfreie geführte Gatter (FGS) induziert, wodurch das genannte potentialfreie geführte Gatter (FGS) die Übertragung von Ladung von dem genannten zweiten Übertragungsgatter (B) unterbricht, wenn das genannte potentialfreie führende Gatter (FGM) eine von dem genannten ersten Übertragungsgatter (C) übertragene Überschußladung erfaßt.

4. Der Analog-Digital-Wandler nach Anspruch 3, in dem die genannte Übertragungsgatter-Vorrichtung weiterhin ein drittes Übertragungsgatter (D) in Ladungspaket übertragender Beziehung mit dem genannten zweiten Übertragungsgatter (D) jegliche Ladung überträgt, die in dem genannten zweiten Übertragungsgatter (B) verbleibt, welches durch das genannte potentialfreie geführte Gatter (FGS) gesperrt sein könnte, wobei das Ladungsniveau auf dem genannten dritten Übertragungsgatter (D) durch das Verarmungsniveau bestimmt ist, das durch ein angelegtes Spannungsniveau (V4) hervorgerufen ist.

5. Der Analog-Digital-Wandler nach Anspruch 3 oder 4, in dem die genannte Spannung (VS), die an die genannten potentialfreien führenden und geführten Gattern angelegt ist, über einen spannungsgeschalteten Feldeffekttransistor (FET) angelegt wird.

6. Ein Analog-Digital-Wandler nach einem der Ansprüche 1 bis 5, in dem eine Vielzahl der genannten Zellen in Reihenanordnung auf dem genannten einzelnen integrierten Schaltkreis-Chip in ladungsübertragender Nähe zueinander angeordnet sind, um dadurch ein Analog-Digital-Register der genannten Vielzahl von Zellen zu bilden.

7. Ein Analog-Digital-Wandler nach Anspruch 6, der ein zusätzliches Übertragungsgatter zwischen jedem dicht aneinanderliegenden Paar der genannten Zellen beinhaltet, um Ladungsübertragung von Zelle zu Zelle zu. bewirken, wobei Ladungen bei Übersteigen der Übertragungsfähigkeit innerhalb der ersten Zelle in der Reihe durch das genannte Übertragungsgatter zur zweiten Zelle übertragen werden und sich dies durch die Reihe fortsetzt, bis die gesamte hereinkommende Ladung innerhalb der ·Zellen übertragen wurde, wobei der Ausgang derjenigen Zellen, zu denen Ladung von der vorhergehenden Zelle übertragen wurde, einen anderen logischen Zustand aufweist als der Ausgang derjenigen Zellen, zu denen keine Ladung übertragen wurde, wodurch ein digitales logisches Signal angezeigt wird, das dem analogen Eingangsladungsniveau entspricht.

8. Der Analog-Digital-Wandler nach Anspruch 7, in dem die Ausgangssignale von dem genannten Register ein Grauniveau anzeigen, falls die analoge Eingangsladung, die an dem genannten Wandler anliegt, einem Bildsignal von sich ändernden Schattenniveaus entspricht.

9. Der Analog-Digital-Wandler nach Anspruch 7, in dem das Ausgangssignal eine digitale logische Darstellung des angelegten analogen Ladungsniveaus gemäß dem Verhältnis S/N ist, wobei S die Nummer der Stufe in dem Wandler ist, in der das Ausgangssignal der ersten Zelle des Wandlers bezüglich der übrigen Zellen des Wandlers wechselt, und N die Anzahl der Zellen in dem Wandler ist.

FIG. 1

FIG. 2

FIG. 3